# EUROPEAN PATENT SPECIFICATION

(11) **EP 1 456 860 B1**
(45) Date of publication and mention of the grant of the patent: **12.01.2011**
(21) Application number: 02776615.3
(22) Date of filing: 22.11.2002
(51) Int. Cl.: H01G 9/20, G01J 1/10, G01J 1/18, G01J 1/44, H04N 5/235

(54) **ACTIVE PIXEL SENSOR**
AKTIV-PIXEL-SENSOR
CAPTEUR A PIXEL ACTIF

(30) Priority: 22.11.2001 AU PR900501
(43) Date of publication of application: 15.09.2004
(73) Proprietor: Silverbrook Research Pty. Limited, Balmain, NSW 2041 (AU)
(72) Inventor: HENDERSON, Peter, Charles, Boyd, Balmain, New South Wales 2041 (AU); SHIPTON, Gary, Balmain, New South Wales 2041 (AU)
(74) Representative: Moore, Barry
(86) International application number: PCT/AU2002/001573
(87) International publication number: WO 2003/044814

(56) References cited:
- EP-A2- 0 682 448
- EP-B1- 0 450 261
- US-A- 4 291 979
- US-A- 4 330 210
- US-A- 4 530 585
- US-A- 4 836 682
- US-A- 5 793 230
- US-A- 5 793 357

## Description

### FIELD OF INVENTION

The present invention relates to image sensors and, in particular, to an active pixel sensor for use in ambient light conditions together with a controlled light source, the sensor being able to discount the effects of the ambient light.

### CO-PENDING APPLICATIONS

Various methods, systems and apparatus relating to the present invention are disclosed in the following co-pending applications filed by the applicant or assignee of the present invention simultaneously with the present invention:
PCT/AU02/01573, PCT/AU02/01572

Various methods, systems and apparatus relating to the present invention are disclosed in the following co-pending applications filed by the applicant or assignee of the present invention on 15 October 2002:
PCT/AU02/01391, PCT/AU02/01392, PCT/AU02/01393, PCT/AU02/01394 and PCT/AU02/01395.

Various methods, systems and apparatus relating to the present invention are disclosed in the following co-pending applications filed by the applicant or assignee of the present invention on 26 November 2001:
PCT/AU01/01527, PCT/AU01/01528, PCT/AU01/01529, PCT/AU01/01530 and PCT/AU01/01531.

Various methods, systems and apparatus relating to the present invention are disclosed in the following co-pending applications filed by the applicant or assignee of the present invention on 26 November 2001:
PCT/AU01/01527, PCT/AU01/01528, PCT/AU01/01529, PCT/AU01/01530 and PCT/AU01/01531.

Various methods, systems and apparatus relating to the present invention are disclosed in the following co-pending applications filed by the applicant or assignee of the present invention on 11 October 2001: PCT/AU01/01274.

Various methods, systems and apparatus relating to the present invention are disclosed in the following co-pending applications filed by the applicant or assignee of the present invention on 14 August 2001: PCT/AU01/00996.

Various methods, systems and apparatus relating to the present invention are disclosed in the following co-pending applications filed by the applicant or assignee of the present invention on 27 November 2000:

| | | | |
|---|---|---|---|
| PCT/AU00/01442, | PCT/AU00/01444, | PCT/AU00/01446, | PCT/AU00/01445, |
| PCT/AU00/01450, | PCT/AU00/01453, | PCT/AU00/01448, | PCT/AU00/01447, |
| PCT/AU00/01459, | PCT/AU00/01451, | PCT/AU00/01454, | PCT/AU00/01452, |
| PCT/AU00/01443, | PCT/AU00/01455, | PCT/AU00/01456, | PCT/AU00/01457, |
| PCT/AU00/01458 and | PCT/AU00/01449. | | |

Various methods, systems and apparatus relating to the present invention are disclosed in the following co-pending applications filed by the applicant or assignee of the present invention on 20 October 2000:

| | | | |
|---|---|---|---|
| PCT/AU00/01273, | PCT/AU00/01279, | PCT/AU00101288, | PCT/AU00/01282, |
| PCT/AU00/01276, | PCT/AU00/01280, | PCT/AU00/01274, | PCT/AU00/01289, |
| PCT/AU00/01275, | PCT/AU00/01277, | PCT/AU00/01286, | PCT/AU00/01281, |
| PCT/AU00/01278, | PCT/AU00/01287, | PCT/AU00/01285, | PCT/AU00/01284 and |
| PCT/AU00/01283. | | | |

Various methods, systems and apparatus relating to the present invention are disclosed in the following co-pending applications filed by the applicant or assignee of the present invention on 15 September 2000: PCT/AU00/01108, PCT/AU00/01110 and PCT/AU00/01111.

Various methods, systems and apparatus relating to the present invention are disclosed in the following co-pending applications filed by the applicant or assignee of the present invention on 30 June 2000:

| | | | |
|---|---|---|---|
| PCT/AU00/00762, | PCT/AU00/00763, | PCT/AU00/00761, | PCT/AU00/00760, |
| PCT/AU00/00759, | PCT/AU00/00758, | PCT/AU00/00764, | PCT/AU00/00765, |
| PCT/AU00/00766, | PCT/AU00/00767, | PCT/AU00/00768, | PCT/AU00/00773, |
| PCT/AU00/00774, | PCT/AU00/00775, | PCT/AU00/00776, | PCT/AU00/00777, |
| PCT/AU00/00770, | PCT/AU00/00769 | PCT/AU00/00771, | PCT/AU00/00772 |
| PCT/AU00/00754, | PCT/AU00/00755, | PCT/AU00/00756 and | PCT/AU00/00757. |

Various methods, systems and apparatus relating to the present invention are disclosed in the following co-pending applications filed by the applicant or assignee of the present invention on 24 May 2000:

| | | | |
|---|---|---|---|
| PCT/AU00/00518, | PCT/AU00/00519, | PCT/AU00/00520, | PCT/AU00/00521, |
| PCT/AU00/00522, | PCT/AU00/00523, | PCT/AU00/00524, | PCT/AU00/00525, |
| PCT/AU00/00526, | PCT/AU00/00527, | PCT/AU00/00528, | PCT/AU00/00529, |
| PCT/AU00/00530, | PCT/AU00/00531, | PCT/AU00/00532, | PCT/AU00/00533, |
| PCT/AU00/00534, | PCT/AU00/00535, | PCT/AU00/00536, | PCT/AU00/00537, |
| PCT/AU00/00538, | PCT/AU00/00539, | PCT/AU00/00540, | PCT/AU00/00541, |
| PCT/AU00/00542, | PCT/AU00/00543, | PCT/AU00/00544, | PCT/AU00/00545, |
| PCT/AU00/00547, | PCT/AU00/00546, | PCT/AU00/00554, | PCT/AU00/00556, |
| PCT/AU00/00557, | PCT/AU00/00558, | PCT/AU00/00559, | PCT/AU00/00560, |
| PCT/AU00/00561, | PCT/AU00/00562, | PCT/AU00/00563, | PCT/AU00/00564, |
| PCT/AU00/00565, | PCT/AU00/00566, | PCT/AU00/00567, | PCT/AU00/00568, |
| PCT/AU00/00569, | PCT/AU00/00570, | PCT/AU00/00571, | PCT/AU00/00572, |
| PCT/AU00/00573, | PCT/AU00/00574, | PCT/AU00/00575, | PCT/AU00/00576, |
| PCT/AU00/00577, | PCT/AU00/00578, | PCT/AU00/00579, | PCT/AU00/00581, |
| PCT/AU00/00580, | PCT/AU00/00582, | PCT/AU00/00587, | PCT/AU00/00588, |
| PCT/AU00100589, | PCT/AU00/00583, | PCT/AU00/00593, | PCT/AU00/00590, |
| PCT/AU00/00591, | PCT/AU00/00592, | PCT/AU00/00594, | PCT/AU00/00595, |
| PCT/AU00/00596, | PCT/AU00/00597, | PCT/AU00/00598, | PCT/AU00100516, |
| PCT/AU00/00517 and | PCT/AU00/00511. | | |

### BACKGROUND

Image sensors need to overcome a number of obstacles when used in the presence of ambient light. One such obstacle is that ambient light may illuminate a scene in a non-uniform manner. In particular, objects obstructing the ambient light source may cast shadows on the scene thereby degrading the image quality. This can be particularly problematic for machine vision systems which attempt to extract certain key features from an image. Whilst it may be possible to post-process an image to reduce the effects of non-uniform illumination, the sensor itself must handle the full dynamic range of light arriving from the scene.

It is desirable to provide an image sensor which is able to be used with a controlled light source in such a way that the effect of illumination by ambient light is discounted. It is also desirable to provide an active pixel sensor which is able to discount the effects of ambient light at the pixel level.

### SUMMARY OF INVENTION

According to a first aspect of the present invention, there is provided a sensor as defined in claim 1.

Preferred embodiments are defined in the dependent claims.

### BRIEF DESCRIPTION OF DRAWINGS

Preferred and other embodiments of the invention will now be described, by way of non-limiting example only, with reference to the accompanying drawings, in which:
Figure 1 is a schematic diagram of a sensor according to the present invention in its simplest form;
Figure 2 is a schematic diagram of a preferred embodiment of the sensor of the present invention; and
Figure 3 shows a timing diagram for waveforms applied to the sensors of Figures 1 and 2.

### DETAILED DESCRIPTION OF PREFERRED AND OTHER EMBODIMENTS

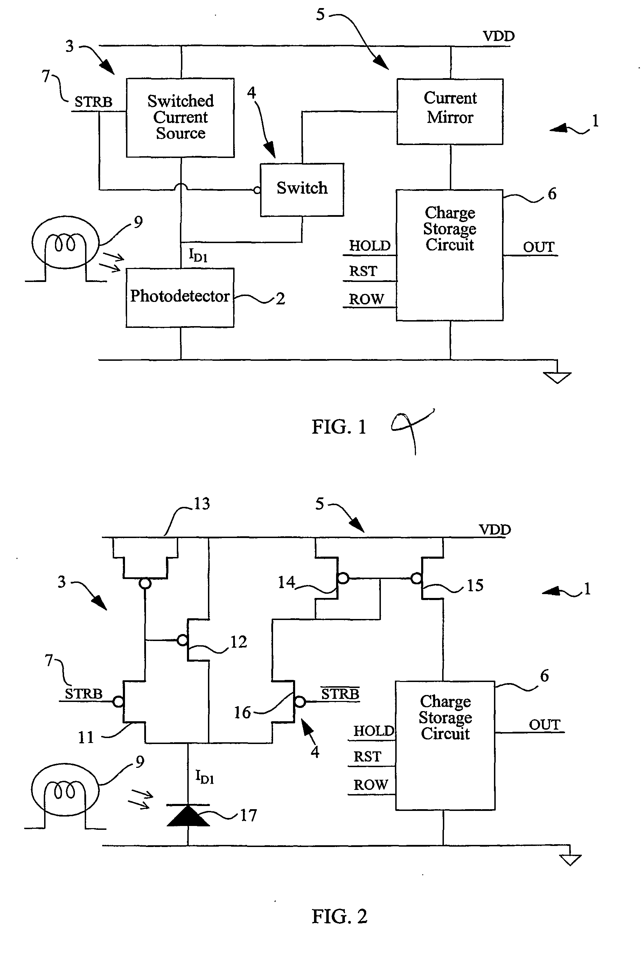

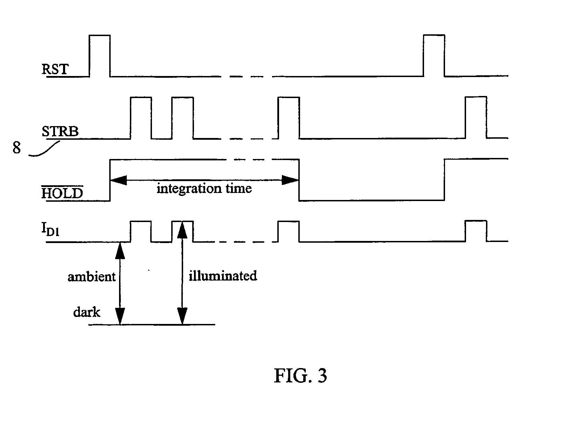

Figure 1 is a schematic diagram of a sensor according to the present invention in its simplest form. As shown in that Figure, the sensor 1 includes a photodetector 2, a switched current source 3, a switch 4, a current mirror 5 and a charge storage circuit 6. The sensor 1 also includes a strobe input 7 which provides a strobing signal 8 (Figure 3) to both the switched current source 3 and the switch 4.

The strobing signal 8 is synchronised with a controlled light source 9 such that when the controlled light source is on, the strobing signal is high and when the controlled light source is off, the strobing signal is low. A waveform of the strobing signal 8 is shown in Figure 3.

During an integration (or "exposure") period, the photodetector 2 produces a photocurrent which is proportional to the intensity of light incident upon the photodetector. When the controlled light source 9 is off the light incident upon the photodetector will primarily be ambient light. When the controlled light source is on, the light incident upon the photodetector will be due to light from both the controlled light source and from ambient light.

The sensor is designed to operate in two phases. As shown in Figure 1, during the first phase the controlled light source 9 is off and the strobing signal 8 is low. During this phase the photocurrent in the photodetector 2 is principally due to ambient light ("the ambient light signal"). Because the strobing signal 8 is low it has the effect of turning the switch 4 off, so that the ambient light current set by the photodetector 2 flows through the switched current source 3. During this first phase the switched current source adapts to the ambient light current and effectively memorises it.

In the second phase the controlled light source 9 is on and the strobing signal is high. At this stage the photocurrent in the photodetector 2 increases in proportion to the light incident upon the photodetector from both the controlled light source and the ambient light. We shall refer to this combined signal as a "total light current."

Because the strobing signal 8 is high, the switched current source now draws a fixed amount of the photocurrent, corresponding to the memorised ambient light current. The current set by the photodetector in this phase exceeds the current memorized by the switched current source, and so a differential current corresponding to the difference between the ambient light current and the total light current is pulled through switch 4, opened by the strobing signal 8. This in turn causes the current mirror 5 to generate a current that is related to the differential current drawn through the switch 4. The current generated by the current mirror 5 is stored in the charge storage circuit 6.

As the strobing signal 8 alternates between high and low signals during the integration period, the difference signal is accumulated in the charge storage circuit 6. Since the difference signal is proportional to light incident upon the photodetector 2 due principally to the controlled light source, the accumulated charge reflects the light incident on the pixel due to the controlled light source and effectively discounts the impact of ambient light.

Figure 2 shows a more detailed schematic diagram of a preferred embodiment of the sensor of the present invention. Common features of Figures 2 and 1 are referred to using the same numerals.

As shown in Figure 2, the sensor includes includes a photodiode 17, a switched current source 3, a switch 4, a current mirror 5 and a charge storage circuit 6. The circuit 1 also includes a strobe input 7 which provides a strobing signal 8 (Figure 3) to both the switched current source 3 and the switch 4.

As in the example of Figure 1, the strobing signal 8 is synchronised with a controlled light source 9 such that when the controlled light source is on, the strobing signal is high and when the controlled light source is off, the strobing signal is low. Once again, a waveform of the strobing signal is shown in Figure 3.

In this embodiment, the switched current source 3 takes the form of transistors 11, 12 and 13, the current mirror 5 takes the form of transistors 14 and 15, and the switch 4 takes the form of a single transistor 16.

As with the example of Figure 1, the photodiode 17 in this example produces a photocurrent which is proportional to the intensity of light incident upon the photodiode during the integration period. When the controlled light source is off the light incident upon the photodiode will primarily be ambient light. When the controlled light source is on, the light incident upon the photodiode will be due to light from both the controlled light source and from ambient light.

Again, the sensor is designed to operate in two phases. As shown in Figure 2, during the first phase the controlled light source 9 is off and the strobing signal 8 is low. During this phase the photocurrent in the photodiode 17 is determined by ambient light ("the ambient light current"). Because the strobing signal 8 is low it has the effect of turning transistor 11 on and switch 4 (transistor 16) off. During this first phase the drain and gate of transistor 12 are connected together thereby causing transistor 12 to act like a diode. After a short time, the circuit reaches equilibrium and the current through transistor 12 is equal to the photocurrent of the photodiode 17. Transistor 13 provides additional capacitance and has across it the corresponding voltage to support the current in transistor 12. In this way, the switched current source 3 effectively memorises the ambient light signal 10 which reflects the photocurrent in the photodiode 17 due principally to ambient light.

In the second phase the controlled light source 9 is on and the strobing signal is high. At this stage the photocurrent in the photodiode 17 increases in proportion to the light incident upon the photodiode from both the controlled light source and the ambient light. As mentioned earlier, we shall refer to this combined signal as a "total light current." When the controlled light source 9 is on, the strobing signal 8 is high. This causes transistor 11 to turn off and switch 4' to turn on. The voltage across transistor 13 in the switched current source 3 is maintained by virtue of the capacitance in transistor 13 so that the current through transistor 12 remains the same as when the controlled light source was off.

Because the strobing signal 8 is high, the switched current source now draws a fixed amount of the photocurrent, corresponding to the memorised ambient light current. The excess photocurrent, corresponding to the difference between the ambient light signal and the total light signal, is drawn through switch 4, opened by the strobing signal 8. This, in turn, causes a current to be established through both transistors 14 and 15 of the current mirror 5. As mentioned earlier we refer to this difference current as a "difference signal."

The effect of the current mirror is that the voltage across the photodiode 17 remains approximately constant thus minimising the effect of parasitic capacitance and output impedance of transistor 12 in the switched current source 3.

The output of transistor 15 is connected to the charge storage circuit 6. The charge storage circuit is controlled by a reset signal indicated as "RST" and an optional "HOLD" signal. When the reset condition is removed, the difference signal in the form of current pulses from transistor 15 may be accumulated as charge during the integration period of the pixel. The final voltage may then be sampled on signal "OUT" by enabling signal "ROW."

The number of current pulses used during the integration period is determined by the needs of a particular implementation. The number of current pulses chosen should balance the dual needs of minimising any error due to image motion with the speed requirements of the circuit.

The charge storage circuit 6 may incorporate mechanisms to protect the integrity of the stored difference signal in order to prevent or minimise degradation of the signal after the end of the integration period and before signal readout. As described in Published PCT Patent Application No WO 01/63905 (Fossum, E. et al), these protection mechanisms may include a light shield to prevent or minimise a light-induced signal from affecting the stored signal. Such protection mechanisms may also include an enclosing guard band to prevent unwanted signal incursion from adjacent areas.

Those skilled in the art will appreciate that a number of alternative embodiments and examples are available, including inverting the circuit and the strobing signal so that the strobing signal is low when the controlled light source is on and so that the strobing signal is high when the controlled light source is off. Along the same lines, although it is assumed that the photo diode D1 is an N-type diffusion on P-type substrate, a P-type diffusion in an N-well photo diode may also be used provided the polarity of all transistors and supply voltage is changed accordingly. In addition, the circuit may be replicated many times to form an array of pixels. Such an array of pixels is included in the scope of the present invention. Furthermore, the current mirror 5 may technically be excluded from the circuit. The purpose of the current mirror 5 is to account for voltage changes in the circuit by ensuring that the voltage drop across the current mirror is approximately equal to the voltage drop across the switched current source 3. The inventors are of the opinion that the circuit works better with a current mirror, but this feature may be excluded.

It will be appreciated from the foregoing discussion that the present invention may advantageously be used to provide an improved image suitable for machine vision applications where the scene is in motion with respect to the image sensor, and in particular such as in motion sensing pens of the types described in US Patent 5,051,736 (Bennett, W.E. et al), US Patent 5,477,012 (Sekendur, O.F.), US Patent 5,652,412 (Lazzouni, M. et al), PCT Patent Application WO 00/72230 (Silverbrook, K. et al), PCT Patent Application WO 01/16872 (Faahraeus, C. et al). In such embodiments of the present invention it is desirable that the sensing device incorporate timing circuitry adapted to provide the strobing signal to both the controlled light source and the array of pixels.

The present invention has been described with reference to a number of preferred embodiments. However, it will be appreciated by those skilled in the art that a number of other embodiments, differing from those specifically described, will also fall within the scope of the present invention as defined by the appended claims.

## Claims

1. A sensor (1) comprising:
a controlled light source (9);
a photo detector (2); a timing circuitry for providing a strobing signal (8) to the controlled light source, thereby synchronizing the strobing signal with the controlled light source;
a processing circuitry comprising a switched current source; and
a storage circuitry (6),
wherein the switched current source (3) includes a first transistor (12) and a second transistor (13) providing additional capacitance: the sensor is configured to alternate between first and second phases in response to the strobing signal (8)
the sensor wherein:
in the first phase:
(a) the photo detector (2) is configured to sense ambient light and generate an ambient light current in response thereto;
(b) the timing circuitry provides a low strobing signal for connecting together the drain and gate of the first transistor (12): and
(c) the switched current source is configured to memorise the ambient light current by setting a voltage across the second transistor (13) based on the ambient light current flowing through the first transistor (12); and
in the second phase:
(d) the photo detector (2) is configured to sense ambient light and light from the light source, and generate a total light current in response thereto;
(e) the timing circuitry provides a high strobing signal:
(f) the switched current source is configured to use the voltage set across the second transistor (13) during the first phase so that the current through the first transistor (12) during the second phase remains the same as in the first phase;
such that the switched current source draws a fixed amount of the photocurrent corresponding to the memorised ambient light current thereby generating a difference signal representing the difference between the ambient light current and the total light current; and
(g) the storage circuitry (6) is configured to store charge based on the difference signal.

2. The sensor of claim 1 wherein the photo detector (2) is a photodiode.

3. The sensor of claim 1 wherein the ambient light current is indicative of the intensity of ambient light incident on the photo detector.

4. The sensor of claim 1 wherein the total light current is indicative of the intensity of light incident on the photo detector due to both the controlled light source and the ambient light.

5. The sensor of claim 1, wherein the switched current source (3) is responsive to the strobing signal.

6. The sensor of claim 1 wherein the processing circuitry comprises a switch (4) to route the difference signal, thereby to generate a current for supplying the charge to the storage circuit for storage.

7. The sensor of claim 6 wherein the switch (4) is responsive to the strobing signal inverted.

8. The sensor of claim 1 wherein the storage circuitry (6) incorporates a light shield.

9. The sensor of claim 1 wherein the storage circuitry comprises (6) a charge storage circuit.

10. The sensor of claim 1 wherein the sensor is configured to alternate between the first and second phases at least once during an integration period of the sensor.

11. The sensor of claim 1 wherein the processing circuitry further includes a current mirror (5).

12. The sensor of claim 1 wherein the timing circuitry is configured to generate a strobing signal having a first level and a second level, the controlled light source being configured such that it is on when the strobing signal is at the first level and off when the strobing signal is at the second level.

13. The sensor of claim 12 wherein the timing circuitry is configured to generate a strobing signal which alternates between the first and second levels at least once during an integration period of the sensor.

14. The sensor of claim 12 wherein the first strobing signal level is a high level and the second strobing signal level is a low level.

15. The of claim 1 comprising an active pixel sensor.

16. An array of sensors as claimed in claim 1.

17. An image sensing device comprising a sensor according to claim 1.

18. The device of claim 17 wherein the controlled light source is selected from the group comprising:
(a) a light-emitting diode;
(b) a superluminescent light-emitting diode; and
(c) a laser diode.

## Patentansprüche

1. Ein Sensor (1), der folgendes umfasst:
eine gesteuerte Lichtquelle (9);
einen Photodetektor (2);
einen Zeitgeberschaltkreis zur Bereitstellung eines stroboskopischen Signals (8) für die gesteuerte Lichtquelle, wodurch das stroboskopische Signal mit der gesteuerten Lichtquelle synchronisiert wird;
einen Verarbeitungsschaltkreis, der eine geschaltete Stromquelle umfasst; und
einen Speicherschaltkreis (6),
wobei die geschaltete Stromquelle (3) einen ersten Transistor (12) und einen zweiten Transistor (13) einschließt, die eine zusätzliche Kapazitanz bereitstellen;
der Sensor konfiguriert ist, um zwischen einer ersten und zweiten Phase als Reaktion auf das stroboskopische Signal (8) zu wechseln, wobei:
in der ersten Phase:
(a) der Photodetektor (2) konfiguriert ist, um Umgebungslicht aufzunehmen und als Reaktion darauf einen Umgebungslichtstrom zu erzeugen;
(b) der Zeitgeberschaltkreis ein geringes stroboskopisches Signal zur Verbindung von Drain und Gate des ersten Transistors (12) miteinander bereitstellt; und
(c) die geschaltete Stromquelle konfiguriert ist, um den Umgebungslichtstrom einzuprägen, indem eine Spannung über den zweiten Transistor (13) auf der Basis des Umgebungslichtstromes, der durch den ersten Transistor (12) fließt, angelegt wird; und
in der zweiten Phase:
(d) der Photodetektor (2) konfiguriert ist, um das Umgebungslicht und das Licht aus der Lichtquelle wahrzunehmen und als Reaktion darauf einen Gesamtlichtstrom zu erzeugen;
(e) der Zeitgeberschaltkreis ein starkes stroboskopisches Signal bereitstellt;
(f) die geschaltete Stromquelle konfiguriert ist, um die Spannung zu verwenden, die während der ersten Phase über den zweiten Transistor (13) angelegt wurde, so dass der Strom durch den ersten Transistor (12) während der zweiten Phase der gleiche Strom wie in der ersten Phase bleibt;
so dass die geschaltete Stromquelle eine feststehende Menge des Photostromes verbraucht, der dem eingeprägten Umgebungslichtstrom entspricht, wodurch ein Differenzsignal erzeugt wird, das den Unterschied zwischen dem Umgebungslichtstrom und dem Gesamtlichtstrom darstellt; und
(g) der Speicherschaltkreis (6) konfiguriert ist, um eine Ladung auf der Basis des Differenzsignals zu speichern.

2. Der Sensor nach Anspruch 1, wobei der Photodetektor (2) eine Photodiode ist.

3. Der Sensor nach Anspruch 1, wobei der Umgebungslichtstrom die Intensität des Umgebungslichtes anzeigt, das an dem Photodetektor einfällt.

4. Der Sensor nach Anspruch 1, wobei der Gesamtlichtstrom die Intensität des Lichtes anzeigt, das an dem Photodetektor aufgrund sowohl der gesteuerten Lichtquelle als auch des Umgebungslichtes einfällt.

5. Der Sensor nach Anspruch 1, wobei die geschaltete Stromquelle (3) auf das stroboskopische Signal reagiert.

6. Der Sensor nach Anspruch 1, wobei der Verarbeitungsschaltkreis einen Schalter (4) umfasst, um das Differenzsignal zu leiten und **dadurch** einen Strom zur Beförderung der Ladung an den Speicherschaltkreis zur Speicherung zu erzeugen.

7. Der Sensor nach Anspruch 6, wobei der Schalter (4) auf das stroboskopische Signal umgekehrt reagiert.

8. Der Sensor nach Anspruch 1, wobei der Speicherschaltkreis (6) eine Lichtblende einschließt.

9. Der Sensor nach Anspruch 1, wobei der Speicherschaltkreis (6) einen Ladungsspeicherschaltkreis umfasst.

10. Der Sensor nach Anspruch 1, wobei der Sensor konfiguriert ist, um zwischen der ersten und zweiten Phase mindestens einmal während einer Integrationsdauer des Sensors zu wechseln.

11. Der Sensor nach Anspruch 1, wobei der Verarbeitungsschaltkreis ferner einen Stromspiegel (5) einschließt.

12. Der Sensor nach Anspruch 1, wobei der Zeitgeberschaltkreis konfiguriert ist, um ein stroboskopisches Signal mit einem ersten Pegel und einem zweiten Pegel zu erzeugen, wobei die gesteuerte Lichtquelle derart konfiguriert ist, dass sie an ist, wenn sich das stroboskopische Signal bei dem ersten Pegel befindet, und aus ist, wenn sich das stroboskopische Signal bei dem zweiten Pegel befindet.

13. Der Sensor nach Anspruch 12, wobei der Zeitgeberschaltkreis konfiguriert ist, um ein stroboskopisches Signal zu erzeugen, das zwischen dem ersten und zweiten Pegel mindestens einmal während einer Integrationsdauer des Sensors wechselt.

14. Der Sensor nach Anspruch 12, wobei der erste Pegel des stroboskopischen Signals ein hoher Pegel und der zweite Pegel des stroboskopischen Signals ein niedriger Pegel ist.

15. Der Sensor nach Anspruch 1, der einen aktiven Pixelsensor umfasst.

16. Ein Array von Sensoren nach Anspruch 1.

17. Eine Bildaufnahmevorrichtung, die einen Sensor nach Anspruch 1 umfasst.

18. Die Vorrichtung nach Anspruch 17, wobei die gesteuerte Lichtquelle aus der Gruppe ausgewählt ist, die aus folgendem besteht:
(a) eine lichtemittierende Diode;
(b) eine superlumineszierende lichtemittierende Diode; und
(c) eine Laserdiode.

## Revendications

1. Capteur (1) comprenant :
- une source lumineuse commandée (9) ;
- un photodétecteur (2) ;
- un ensemble de circuits de synchronisation pour délivrer un signal de strobage (8) à la source lumineuse commandée, synchronisant de cette façon le signal de strobage avec la source lumineuse commandée ;
- un ensemble de circuits de traitement comprenant une source de courant commutée (3) ; et
- un ensemble de circuits de stockage (6) ;
la source de courant commutée (3) comprenant un premier transistor (12) et un second transistor (13) délivrant une capacité supplémentaire :
le capteur étant configuré pour alterner entre des première et seconde phases en réponse au signal de strobage (8), dans lequel :
dans la première phase :
(a) le photodétecteur (2) est configuré pour détecter une lumière ambiante et générer un courant de lumière ambiante en réponse à celle-ci ;
(b) l'ensemble de circuits de synchronisation délivre un signal de strobage faible pour relier ensemble le drain et la grille du premier transistor (12) ; et
(c) la source de courant commutée est configurée pour mémoriser le courant de lumière ambiante par réglage d'une tension sur le second transistor (13) sur la base du courant de lumière ambiante circulant à travers le premier transistor (12) ; et
dans la seconde phase :
(d) le photodétecteur (2) est configuré pour détecter une lumière ambiante et une lumière provenant de la source lumineuse, et générer un courant de lumière globale en réponse à celles-ci ;
(e) l'ensemble de circuits de synchronisation délivre un signal de strobage élevé ;
(f) la source de courant commutée est configurée pour utiliser la tension réglée sur le second transistor (13) durant la première phase, de telle sorte que le courant à travers le premier transistor (12) durant la seconde phase reste le même que dans la première phase ;
de telle sorte que la source de courant commutée tire une quantité fixe du photocourant correspondant au courant de lumière ambiante mémorisé, générant ainsi un signal de différence représentant la différence entre le courant de lumière ambiante et le courant de lumière globale ; et
(g) l'ensemble de circuits de stockage (6) est configuré pour stocker une charge sur la base du signal de différence.

2. Capteur selon la revendication 1, dans lequel le photodétecteur (2) est une photodiode.

3. Capteur selon la revendication 1, dans lequel le courant de lumière ambiante est indicatif de l'intensité de la lumière ambiante incidente sur le photodétecteur.

4. Capteur selon la revendication 1, dans lequel le courant de lumière globale est indicatif de l'intensité de la lumière incidente sur le photodétecteur due à la fois à la source lumineuse commandée et à la lumière ambiante.

5. Capteur selon la revendication 1, dans lequel la source de courant commutée (3) est réactive au signal de strobage.

6. Capteur selon la revendication 1, dans lequel l'ensemble de circuits de traitement comprend un commutateur (4) pour acheminer le signal de différence, pour générer ainsi un courant destiné à alimenter la charge au circuit de stockage pour le stockage.

7. Capteur selon la revendication 6, dans lequel le commutateur (4) est réactif au signal de strobage inversé.

8. Capteur selon la revendication 1, dans lequel l'ensemble de circuits de stockage (6) incorpore un écran pare-lumière.

9. Capteur selon la revendication 1, dans lequel l'ensemble de circuits de stockage (6) comprend un circuit de stockage de charge.

10. Capteur selon la revendication 1, dans lequel le capteur est configuré pour alterner entre les première et seconde phases au moins une fois durant une période d'intégration du capteur.

11. Capteur selon la revendication 1, dans lequel l'ensemble de circuits de traitement comprend en outre un miroir de courant (5).

12. Capteur selon la revendication 1, dans lequel l'ensemble de circuits de synchronisation est configuré pour générer un signal de strobage ayant un premier niveau et un second niveau, la source lumineuse commandée étant configurée de telle sorte qu'elle est allumée lorsque le signal de strobage est au premier niveau et éteinte lorsque le signal de strobage est au second niveau.

13. Capteur selon la revendication 12, dans lequel l'ensemble de circuits de synchronisation est configuré pour générer un signal de strobage qui alterne entre les premier et second niveaux au moins une fois durant une période d'intégration du capteur.

14. Capteur selon la revendication 12, dans lequel le premier niveau de signal de strobage est un niveau élevé et le second niveau de signal de strobage est un niveau faible.

15. Capteur selon la revendication 1, comprenant un capteur à pixel actif.

16. Réseau de capteurs selon la revendication 1.

17. Dispositif de détection d'image comprenant un capteur tel que défini à la revendication 1.

18. Dispositif selon la revendication 17, dans lequel la source lumineuse commandée est choisie dans le groupe comprenant :
(a) une diode électroluminescente ;
(b) une diode électroluminescente superluminescente ; et
(c) une diode laser.
